# EUROPEAN PATENT SPECIFICATION

(11) **EP 0 465 670 B1**
(45) Date of publication and mention of the grant of the patent: **10.04.1996**
(21) Application number: 91902796.1
(22) Date of filing: 29.01.1991
(51) Int. Cl.: C08F 299/00

(54) **PHOTOCURABLE RESIN COMPOSITION**
LICHTHÄRTBARE HARZZUSAMMENSETZUNG
COMPOSITION DE RESINE PHOTOPOLYMERISABLE

(30) Priority: 30.01.1990 JP 17967/90
(43) Date of publication of application: 15.01.1992
(73) Proprietor: NIPPON PETROCHEMICALS CO., LTD., Tokyo 100 (JP)
(72) Inventor: NARAHARA, Hisao, Tokyo 158 (JP); INOUE, Satoru, Kawasaki-shi, Kanagawa 210 (JP); KUROKI, Teruhisa, Kawasaki-shi, Kanagawa 211 (JP); YAMAGUCHI, Tatsuo, Tokyo 191 (JP); OOMIKA, Hiroyoshi, Yokohama-shi, Kanagawa 233 (JP)
(74) Representative: Bond, Bentley George
(86) International application number: JP9100104
(87) International publication number: WO9111472

(56) References cited:
- EP-A- 0 353 924
- GB-A- 2 048 941
- JP-A- 5 192 887
- JP-A- 5 550 006
- JP-A-51 116 893
- JP-A-63 150 304
- US-A- 3 974 129

## Description

### [Technical Field]

The present invention relates to a photocurable resin composition prepared by mixing a specific modified resin prepared by the modification of a conjugated diene polymer or copolymer with a wax having a specific melting point. Particularly, the present invention relates to a photocurable resin composition suitable for the preparation of a printed wiring board by photocuring.

### [Background Art]

Various processes for the preparation of a printed wiring board have already been developed, among which a process comprising the use of a photocurable and photosensitive resin composition as an etching resist and a process comprising the use of said resin composition as a plating resist have recently been employed predominantly.

The former process comprises forming a layer of a photocurable resin composition on a circuit board substrate by some means, adhering a negative-type circuit pattern mask closely to the layer, irradiating actinic rays on the whole to cure desired portions of the layer, removing uncured portions of the layer by development and then etching the resulting board to form a predetermined circuit pattern.

The latter process comprises irradiating a photocurable resin layer formed on a circuit board substrate with actinic rays through a positive-type pattern mask, removing desired portions of the resin layer by development, plating the desired portions with, e.g., etching-resistant solder, stripping off undesired portions of the resin layer and then etching the resulting board to obtain a predetermined circuit pattern.

The "circuit pattern mask" used in the above processes corresponds to a photographic negative and comprises a light-barrier layer for forming a suitable pattern on a transparent substrate. Although glass may be used as the substrate or base, a plastic film such as polyester film is predominantly used at present. The material of the light-barrier layer is generally chromium, silver or other metal.

The photocurable resin composition used in the above processes generally comprises (1) a binder polymer, (2) a photopolymerizable monomer or oligomer (as a crosslinking agent), (3) a photopolymerization initiator and (4) other components such as a stabilizer, colorant and flame retardant.

The binder polymer serves to shape the resin composition into a film and may mainly be an acrylic polymer which is prepared by the copolymerization of acrylic acid, an acrylate ester, methacrylic acid, a methacrylate ester, styrene etc. and has a molecular weight of several tens of thousands.

The photopolymerizable monomer or oligomer also contains an acryloyl or methacrylol group. The principle of the above circuit pattern forming process resides in that such a resin composition is used to form a layer and only desired areas of the layer are insolubilized by light exposure.

Although U.S. Patent No. 3,954,587 discloses a process comprising the use of a specific photocurable composition containing a maleinized oil as a so-called photoresist such as an etching resist, it has been ascertained by the follow-up made by the inventors of the present invention that the resulting coating before irradiation with light is tacky at ordinary temperatures as examined according to the tack test, because the composition used in said patent comprises a maleinized oil and an ethylenically unsaturated compound monomer having at least two unsaturated bonds in the molecule.

In the conventional production of a printed wiring board, a circuit pattern mask is adhered in a vacuum closely to a photosensitive coating formed on a substrate, and the whole is then exposed to UV. If the photosenstive resin coating is tacky at ordinary temperatures, the coating will partially remain adhered to the mask when the mask is attempted to be peeled off the coating after the exposure. Although this adhesion can be prevented by using a cooling apparatus or bath after the exposure step, this means will increase the equipment cost, necessitate one additional step and make the operation troublesome unfavorably. Meanwhile, the application of a release agent to the circuit pattern mask will exert adverse effects on the formation of a fine pattern. Under these circumstances, the inventors of the present invention have reported in EP-A-0 353 924 that a photosensitive resin coating made from a modified resin prepared by adding an α,β-unsaturated dicarboxylic acid anhydride to a conjugated diene polymer or copolymer to form an adduct having a softening point of 70 to 200 °C (as determined by the ring and ball softening point method according to JIS K 2531-60) and reacting the adduct with an α,β-unsaturated mono- or di-carboxylic acid ester having an alcoholic hydroxy group to open a part or the whole of the acid anhydride rings and introduce conjugated double bonds into the adduct, is scarely tacky at ordinary temperatures as examined according to the tack test.

In the practical production of a printed wiring board, the extent of adhesion of a photosensitive coating remaining adhered to a circuit pattern mask after the step of peeling the mask from the coating varies depending upon various conditions such as temperature, pressure and time. In any case, a higher temperature, a higher pressure or a longer time will cause the coating to remain adhered to the mask more easily after the removal of the mask. For example, because the practical production of a printed wiring board is conducted continuously, the temperature of the atmosphere itself is liable to rise by the heat radiation from a light source. Further, the vacuum adhesion of the mask to the photosensitive coating applies a pressure to a substrate for the board. These phenomena are causative of more liability of the coating to remain adhered to the mask.

Therefore, the inventors of the present invention tested the photosensitive coating of EP-A-0 353 924 for its adhesion to a pattern mask after the step of peeling the mask under approximately the same conditions as those for the practical production with the result that the coating of said application was found to be not always satisfactory.

In the above test, a distinct peel noise was heard when the pattern mask was peeled off the coating after light exposure, which means that the coating was not completely tack-free. When the photosensitive resin coating is not completely tack-free, during the repeated use of the pattern mask, which is expensive, in the industrial production of circuit boards, the resin will cumulatively adhere to the peeled mask, which makes further use of the mask impossible or gives a deficient or shortcircuit resist pattern at the worst.

Further, the photosensitive coating formed on a substrate for a wiring board must have a measure of hardness. This is because the steps of producing a printed wiring board are carried out one after another on a conveyor line, that is, a substrate having a photosensitive resin coating formed thereon is transferred to a light exposure step through the conveyor line, during which the coating is liable to be damaged in a case where it is soft. The photosensitive resin coating made from the previously mentioned modified resin is insufficient in this respect.

In JP-A-51-116893, there is disclosed a photocurable composition comprising (a) a reaction product obtained by esterifying a maleic acid anhydride adduct of liquid polybutadiene with a specified hydroxy compound; (b) a specified unsaturated compound, a specified acrylate compound of a specified glycidyl ester compound; and (c) a specified benzoin ether compound.

### [Disclosure of Invention]

An object of the present invention is to provide a composition which can give a substantially tack-free photosensitive coating having a sufficiently high hardness.

This object is achieved by providing a photocurable resin composition comprising
(a) 100 parts by weight of a modified resin prepared by reacting an α,β-unsaturated dicarboxylic acid anhydride adduct having a softening point ranging from 70 to 200 °C (as determined by the ring and ball softening point method, according to JIS K 2531-60) derived from a conjugated diene polymer or copolymer having a number average molecular weight of 500 to 5000 and vinyl group content of 50 mole % or above, with N-methylolacrylamide or with an α,β-unsaturated monocarboxylic acid ester having an alcoholic hydroxy group represented by the following general formula (I), 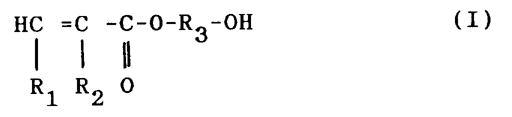 wherein R₁ and R₂ each represent a hydrogen atom or a methyl group; and R₃ represents a hydrocarbon residue having at least 2 carbon atoms which may contain a heteroatom therein,
   to cause ring opening of at least 10 mole % of the acid anhydride present in the adduct.
(b) 0.2 to 10 parts by weight of a wax having a melting point of not higher than 100 °C (as determined by the dropping method according to the ASTM D 127), and
(c) 0.1 to 20 parts by weight of a photopolymerization initiator.

### [Best Mode for Carrying Out the Invention]

The present invention will now be described in more detail.

In the present invention, there is used a modified resin (a) prepared by addition reacting a conjugated diene polymer or copolymer with an α,β-unsaturated dicarboxylic acid anhydride to form an adduct having a softening point of 70 to 200 °C (as determined by the ring and ball softening point method according to JIS K 2531-60) and reacting the thus obtained adduct with N-methylolacrylamide or with an α,β-unsaturated monocarboxylic acid ester having an alcoholic hydroxy group to cause ring opening of a part or the whole of the acid anhydride present in the adduct.

The conjugated diene polymer or copolymer to be used in the resin composition of the present invention is a lower polymer of a conjugated diolefin having 4 or 5 carbon atoms, such as butadiene or isoprene, or a copolymer of low degree of polymerization comprising one or more of these conjugated diolefins and an ethylenically unsaturated monomer other than the conjugated diolefins, said monomer being particularly selected from among aliphatic and aromatic monomers such as isobutylene, diisobutylene, styrene, α-methylstyrene, vinyltoluene and divinyltoluene. Alternatively, a mixture of two or more of the polymers and the copolymers may be used.

The above conjugated diene polymer or copolymer is one having a vinyl content of 50 mole % or above and a number average molecular weight ranging from 500 to 5000. A conjugated diene polymer or copolymer having a vinyl content of less than 50 mole % will give too low a crosslinking density unfavorably. Further, a conjugated diene polymer or copolymer having a number average molecular weight of less than 500 will give a photosensitive coating poor in strength, while one having a number average molecular weight exceeding 5000 will not give any smooth coating unfavorably.

The preparation of the above modified resin can be conducted as follow.

The conjugated diene polymer or copolymer can be prepared by conventional processes. Typical one of these processes comprises anionically polymerizing one or more conjugated diolefins having 4 or 5 carbon atoms preferably together with an aromatic vinyl monomer such as styrene, α-methylstyrene, vinyltoluene or divinyltoluene in an amount of at most 50 mole % based on the conjugated diolefins in the presence of an alkali metal or organoalkali metal compound as a catalyst at a temperature of 0 to 100 ^{o}C. In this case, to obtain a light-colored polymer or copolymer having a controlled molecular weight and a lowered gel fraction is desired, it is suitable to employ a chain transfer polymerization process using an organoalkali metal compound such as benzyl sodium and a compound having an alkylaryl group such as toluene as a chain transfer agent (see U.S. Patent No. 3,789,090), a living polymerization process which comprises conducting the polymerization in tetrahydrofuran as a solvent in the presence of a polycyclic aromatic compound such as naphthalene as an activator and an alkali metal catalyst such as sodium, or a process characterized by modifying the molecular weight by the use of an aromatic hydrocarbon such as toluene or xylene as a solvent and a dispersion of a metal such as sodium as a catalyst and the addition of an ether such as dioxane. Further, there may be used a lower polymer prepared by the coordination anionic polymerization using an acetylacetonate of a Group VIII metal of the periodic table, such as cobalt or nickel, or an alkylaluminum halide as a catalyst.

Then, the conjugated diene polymer or copolymer is addition reacted with an α,β-unsaturated dicarboxylic acid anhydride to form an adduct.

The α,β-unsaturated dicarboxylic acid anhydride to be used in the present invention includes maleic anhydride, citraconic anhydride and chloromaleic anhydride.

Generally, the above addition reaction is conducted at a temperature of 100 to 250 ^{o}C in an inert solvent in which either the (co)polymer or the anhydride or both of them are soluble. In this addition reaction, 0.1 to 0.3 part by weight of hydroquinone, catechol or a p-phenylenediamine derivative is used as an antigelling agent.

According to the present invention, the addition of an α,β-unsaturated dicarboxylic acid anhydride must be conducted so as to give an adduct having a softening point ranging from 70 to 200 °C (as determined by the ring and ball softening point method according to JIS K 2531-60). If the softening point is lower than 70 °C, the resulting coating will be tacky, while if it exceeds 200 °C, no smooth coating will be formed unfavorably. The softening point varies mainly depending upon the unsaturated bond content and molecular weight of the conjugated diene polymer or copolymer used as the raw material and the amount of the α,β-unsaturated dicarboxylic acid anhydride added to the (co)polymer. For example, when a liquid polybutadiene having a number average molecular weight of 1,000 is used, an adduct obtained must have a total acid number of 400 mgKOH/g or above.

In the next step, the adduct of the acid anhydride obtained as mentioned above is reacted with N-methylolacrylamide or with an *α,*β-unsaturated monocarboxylic acid ester having an alcoholic hydroxy group represented by said formula (I) to prepare a modified resin (a) in which at least a part of the acid anhydride groups present in the adduct has been subjected to ring opening.

The carbon number of R₃ group in said formula (I) is preferably 2 to 20 and a preferable heteroatom which may contain in R₃ group is nitrogen or oxygen atom.

Examples of the α,β-unsaturated monocarboxylic acid ester having an alcoholic hydroxyl group represented by the above general formula (I) include 2-hydroxyethyl acrylate, 2-hydroxylethyl methacrylate, 2-hydroxypropyl acrylate, 2-hydroxypropyl methacrylate, 2-hydroxy-3-phenoxypropyl acrylate and 2-hydroxy-3-phenoxypropyl methacrylate, which may be used singly or jointly.

The ring opening reaction of the acid anhydride groups is generally conducted in the presence of a base catalyst at a relatively low temperature of 100 °C or below. It is preferable to use a solvent which is inert to N-methylolacrylamide or the unsaturated monocarboxylic acid ester and acid anhydride groups and can dissolve both of them therein in the ring opening reaction. Examples of such a solvent include aromatic hydrocarbons such as toluene and xylene; ketones such as methyl ethyl ketone and methyl isobutyl ketone; esters such as ethyl acetate; ethers free from hydroxyl group such as diethylene glycol dimethyl ether and triethylene glycol dimethyl ether; and tertiary alcohols such as diacetone alcohol.

In any case, it is suitable in view of photocurablility that the extent of ring opening by reaction with an α,β-unsaturated monocarboxylic acid ester having an alcoholic hydroxyl group extends to not less than 10 mol %, preferably not less than 30 mol %, of the acid anhydride groups. If the extent is less than 10 mol %, the resulting modified resin will unfavorably be insufficient in photocurability.

Thus the modified resin (a) according to the present invention is prepared.

0.2 to 10 parts by weight of a wax having a melting point not higher than 100 °C as the component (b) are incorporated into 100 parts by weight of said modified resin (a). According to the present invention, a coating obtained from the photocurable resin composition not only has a substantially tack-free property but also exhibits improved pencil hardness.

It is not theoretically clear why the specific effect is obtained by addition of a wax in accordance with the invention, but it is assumed as follows:

In general, the coating composition is applied to an article to be coated whether with an applicator or by electrodeposition, and then dried at a temperature of not higher than 120 °C, preferably not higher than 100 °C, for 5 to 20 minutes to remove the solvent or both the solvent and water contained in the composition. At this time, it is considered according to the present invention that the wax portion having a light gravity in the composition bleeds to form a thin wax film which in turn covers the surface of the coating thereby to improve the coating surface in quality.

Examples of waxes (b) used herein are animal and vegetable waxes such as haze wax (Japan wax), carnauba wax, cotton wax and beeswax, mineral waxes such as montan wax, and synthetic waxes such as petroleum wax, polyethylene wax and Fisher-Tropsh wax which are produced in the course of the refining of petroleum. The preferable wax is a maleinized one addition reacted with maleic acid. The maleinized wax is prepared by addition reacting any of the above waxes with maleic anhydride by a conventional process. These waxes can be used singly or jointly. A maleinized wax as a preferable wax is one prepared by addition reacting with maleic anhydride group in such an amount as to give a maleinized wax whose half acid number is 1 to 150 mg KOH/g, preferably 20 to 100 mg KOH/g.

It is necessary for the wax, the component (b), to have a melting point of not higher than 100 ^{o}C (as determinbed by the dropping method according to ASTM D 127). If the melting point exceeds 100 ^{o}C, the resulting coating will be insufficient in smoothness whereby it is made undesirable for the formation of fine patterns. In addition, it is necessary to add the wax in an amount by weight of 0.2 - 10 parts per 100 parts by weight of said modified resin (a). If the amount of the wax added is less than 0.2 parts by weight, the resulting coating will be tacky, and if it exceeds 10 parts by weight, the resulting coating will be insuffucient in pattern formability.

The wax, the component (b), may be mixed directly with the modified resin, the component (a), or it may be dissolved or dispersed in a suitable solvent for the subsequent mixing with the resin (a). In a case where the wax is in the form of a water dispersion, it may be mixed with the modified resin when this resin is dispersed or may be mixed directly with an aquous dispersion of the modified resin. Thus, for the mixing, there may be employed any mixing method which is suitable depending on the kind of a wax to be mixed.

The photopolymerization initiator (c) to be used in the present invention may be any conventional one and includes not only benzoin, benzoin methyl ether, benzoin methyl ether, benzoin isobutyl ether, benzil, Michler's ketone and 2,4-diethylthioxanthone but also compounds commercially available under the trade name of Irgacures 184, 651 and 907 (products of Ciba-Geigy) and Darocure 1173 (a product of Merck & Co.), which may be used singly or jointly. The photopolymerization initiator is used in an amount of 0.1 to 20 parts by weight per 100 parts by weight of the modified resin (a). If the amount is less than 0.1 part by weight, the photocurability of the resulting composition will be unfavorably low, while if it exceeds 20 parts by weight, the strength of the resulting photosensitive coating will be lowered unfavorably.

An arbitrary fourth component may be added to the composition of the present invention in such a range as not to make the coating tacky. The fourth component includes photopolymerizable monomers such as trimethylolpropane triacrylate and pentaerythritol triacrylate or aminoacrylate.

The photocurable resin composition of the present invention comprising the modified resin (a), wax (b) and the photopolymerization initiator (c) may be coated with a roll coater or an applicator in the form of a so-called varnish prepared by dissolving it in a suitable solvent or may be electrodeposited in the form of an aqueous solution or dispersion.

When the composition is applied by electrodeposition, it is suitable to neutralize at least 10 % of the carboxyl groups present in the modified resin (a) with a conventional base to thereby make the resin soluble or dispersible in water. When the extent of neutralization is too low, the resulting composition will be poor in water solubility or dispersibility, thus being unfit for water-based coating material. The base to be used in the neutralization includes ammonia; amines such as diethylamine, triethylamine, monoethanolamine, diethanolamine, N,N-dimethylethanolamine and N,N-dimethylbenzylamine; and potassium hydroxide. If necessary, various organic solvents may be added to the composition for the purpose of improving the water solubility or dispersibility of the composition or controlling the flowability of the coating. Examples of such organic solvents include water-soluble ones such as ethyl Cellosolve, butyl Cellosolve, ethylene glycol dimethyl ether, diacetone alcohol, 4-methoxy-4-methylpentanone-2 and methyl ethyl ketone; and nonaqueous ones such as xylene, toluene, methyl isobutyl ketone and 2-ethylhexanol.

The composition for electrodeposition coating, prepared by the neutralization described above, is a water-based one and is therefore apparently advantageous in respect of safeness and production.

The photocurable resin composition of the present invention may suitably contain a conventional heat polymerization stabilizer such as hydroquinone, 2,6-di-t-butyl-p-cresol, p-benzoquinone, hydroquinone monomethyl ether,phenothiazine or α-naphthylamine.

Although the photosensitive composition of the present invention can be applied to an arbitrary substrate, a case of applying it to copper-clad laminate will be described as an example.

The application of the composition according to the present invention to a copper-clad laminate may be conducted either by a conventional dip, roll or curtain coating method or by converting the composition into a water-based coating material according to a conventional process and electrodepositing the water-based coating material. The drying is conducted generally at 120 ^{o}C or below, preferably at 100 ^{o}C or below, for 5 to 20 minutes. When the drying temperature exceeds 120 ^{o}C, the coating will be heat-cured unfavorably.

The coating thus formed is a tack-free one having a smooth surface which is very useful as a photosensitive coating for the formation of a circuit pattern.

The photosensitive coating formed on a copper-clad laminate is exposed to an actinic radiation such as ultraviolet rays through a negative mask to cure exposed portions of the coating.

Although the actinic radiation to be favorably used in the curing of the coating varies depending upon the absorption wavelength of the photopolymerization initiator, it is generally ultraviolet rays emitted from xenon lamps, metal halide lamps, low-, medium-, high- or ultra-high-pressure mercury vapor lamps, or electron beams or α-, β- or γ-rays emitted from an electron accelerator. The luminous intensity of a light source and the irradiation time may be suitably selected. Further, the irradiation may be conducted either in the open air or in an inert atmosphere such as nitrogen.

After the irradiation, the coating-covered substrate is subjected to development with a suitable developer by which unexposed portions of the coating are dissolved, thereby to bare the conductive film in a circuit pattern. The bared conductive film is removed with an etching agent, followed by the removal of the cured coating with a suitable release agent. Thus, a wiring pattern of extremely high resolution can be obtained. After the development, the remaining coating may be post-cured by the irradiation with UV rays or at a temperature of 120 ^{o}C or above to thereby improve the resistance of the coating to etching.

According to the present invention, a photosensitive coating which is substantially tack-free even when used in practical light exposure equipment and has a sufficiently high hardness can be obtained. Thus, the photocurable composition of the present invention is suitable for the preparation of a printed wiring board of a photosensitive type.

### Preferred Examples of the Invention

The present invention will now be described in more detail by referring to the following Examples and so on, though the present invention is not limited to them.

### Resin Preparation 1

322 g of a liquid butadiene polymer prepared by polymerizing butadiene at 30 °C in the presence of benzyl sodium as a catalyst and toluene as a chain transfer agent and having a number average molecular weight of 1,000, a viscosity of 14 poise (dyne.s/cm) at 25 °C and a 1,2-bond content of 65 %, 245 g of maleic anhdride, 10 g of xylene and 1.1 g of Antigen 6C (a product of Sumitomo Chemical Co., Ltd., trade name) were fed into a 1-ℓ separable flask fitted with a reflux condenser and a nitrogen gas inlet tube and reacted together at 190 °C in a stream of nitrogen for 4.5 hours. The unreacted maleic anhydride and the xylene were distilled off to obtain a maleinized butadiene polymer having a total acid number of 480 mgKOH/g. The polymer had a softening point of 128 °C (as determined by the ring and ball softening point according to JIS K 2531-60).

200 g of the above maleinized butadiene polymer, 180 g of acetone alcohol and 0.2 g of hydroquinone were introduced into a 1-ℓ separable flask fitted with a reflux condenser and a nitrogen/air inlet tube. The flask so charged was immersed in an oil bath at 150 °C and the contents were mildly stirred to dissolve the polymer completely.

117.6 g of 2-hydroxypropyl acrylate and 16 g of triethylamine were added to the reaction mixture while blowing air into the obtained mixture little by little through the inlet tube, and the mixture was stirred at 70 ^{o}C for 6 hours to give a modified resin A.

The nonvolatile content of the modified resin A was 57 % and the acid value thereof was 178 mgKOH/g of resin.

### Example 1

Irgacure 907 (a product of Ciba-Geigy) as a photopolymerization initiator and 2,4-diethylthioxanthone were added to the resin A prepared in Resin Preparation 1 in amounts of 7.2 and 0.8 % by weight based on the solid resin content, respectively, and triethylamine was added in such an amount as to neutralize one-third of the acid groups present in the resin and mixed together at 40 ^{o}C for one hour to form a resin composition. Then, the thus formed resin composition was slowly incorporated with deionized water in such an amount that the solid content of the water-added resin composition was 15 % by weight thereof and with a wax emulsion of the following constitution in such an amount that a ratio by weight of the solid content of said resin composition to that of the wax emulsion was 100:1, thereby to disperse the resin composition and the wax uniformly in the water thus preparing a photocurable electrodeposition coating composition. This photocurable composition had a pH of 6.6 and an electrical conductivity of 1.80 mS/cm.

| Wax emulsion | |
|---|---|
| paraffine wax having a melting point of 57.1 °C | 27.0 % by weight |
| maleinized polyethylene wax | 9.0 % by weight |
| water | the balance |

- note :: The maleinized polyethylene wax has the following properties :

| | |
|---|---|
| acid number (according to ASTM D 1386) | 80 mg KOH/g |
| melting point | 69 °C |
| average molecular weight | 730 |

This composition was electrodeposited on a copper-clad laminate which had preliminarily been brushed, cleaned and degreased, under the conditions which will be described below, drained and then dried at 100 ^{o}C for 5 minutes to give a coating having a thickness of 15 µm.

This coating was subjected to a tack test, photosensitivity test and pencil hardness test which will be described below. The results are given in Table 1.

### (electrodeposition conditions)

- electrodeposition method :: anionic deposition,
- constant current method :: 90 to 110 mA/dm for 3 min.

### Example 2

The modified resin A prepared in Resin Preparation 1 and a wax (a product of Nippon Oil Co., Ltd., 140 degree F paraffin) having a melting point of 60 °C (dropping point:ASTM D 127) and dissolved in toluene were mixed together in such amounts that a ratio by weight of the solid content of the resin to that of the wax solution was 100 : 0.5. The resulting mixture was then incorporated with Irgacure 907 (a product of Ciba-Geigy) as a photopolymerization initiator and 2,4-diethylthioxanthone in amounts of 7.2 and 0.8 % by weight based on the solid content of the resin, respectively, and then the whole was stirred at a temperature not higher than 40 °C for one hour while being shielding from the light, thereby to prepare a photocurable resin composition.

This composition was applied to a copper-clad laminate which had preliminarily been brushed, cleaned and degreased, with an applicator and then dried at 80 °C for 20 minutes to give a coating having a thickness of 15 µm.

The coating was subjected to a tack test, photosensitivity test and pencil hardness test which will be described below. The results are given in Table 1.

### Example 3

Irgacure 907 (a product of Ciba-Geigy) as a photopolymerization initiator and 2,4-diethylthioxanthone were added to the modified resin A prepared in Resin Preparation 1 in amounts of 7.2 and 0.8 % by weight based on the solid content of the resin, respectively, and triethylamine was then added in such an amount as to neutralize one-third of the acid groups present in the resin and mixed together at 40 ^{o}C for one hour to form a resin composition. Then, the thus formed resin composition was slowly incorporated with deionized water in such an amount that the solid content of the water-added resin composition was 15 % by weight thereof and with the same maleinized polyethylene wax as used in Example 1 in such amount that a ratio by weight of the solid content of said resin composition to that of the wax emulsion was 100 : 1, thereby to disperse the resin composition and the wax uniformly in the water thus preparing a photocurable electrodeposition coating composition. This photocurable composition had a pH of 6.6 and an electrical conductivity of 1.77 mS/cm.

This composition was electrodeposited on a copper-clad laminate which had preliminarily been brushed, cleaned and degreased, under the same conditions as those employed in Example 1, drained and then dried at 100 ^{o}C for 5 minutes to give a coating having a thickness of 15 µm.

The coating was subjected to the tack test, photosensitivity test and pencil hardness test which will be described below. The results are given in Table 1.

### Comparative Example 1

Benzoinisobutylether as a photopolymerization initiator was added to the modified resin A prepared in Resin Preparation 1 in an amount of 8 % by weight based on the total solid content, and the whole was then stirred at a temperature of not higher than 40 ^{o}C for one hour to prepare a photocurable resin composition.

The composition was applied to a copper-clad laminate which had preliminarily been brushed, cleaned and degreased, with an applicator and then dried at 80 ^{o}C for 20 minutes to give a coating having a thickness of 15 µm.

The coating was subjected to the tack test, photosensitivity test and pencil hardness test which will be described below. The results are given in Table 1.

### Comparative Example 2

Irgacure 907 (a product of Ciba-Geigy) as a photopolymerization initiator was added to the modified resin A prepared in Resin Preparation 1 in an amount of 8.0 % by weight based on the solid resin content. Triethylamine was added to the obtained mixture in such an amount as to neutralize one-third of the acid groups present in the resin. The resulting mixture was dispersed in water according to a conventional process to give a photocurable composition for electrodeposition coating. This composition had a nonvolatile content of 15 %, a pH of 6.6 and an electrical conductivity of 1.80 mS/cm. The composition was electrodeposited on a copper-clad laminate which had preliminarily been brushed, cleaned and degreased, under the same conditions as those employed in Example 1, drained and then dried at 100 ^{o}C for 5 minutes to give a coating having a thickness of 15 µm.

This coating was subjected to the tack test, photosensitivity test and pencil hardness test which will be described below. The results are given in Table 1.

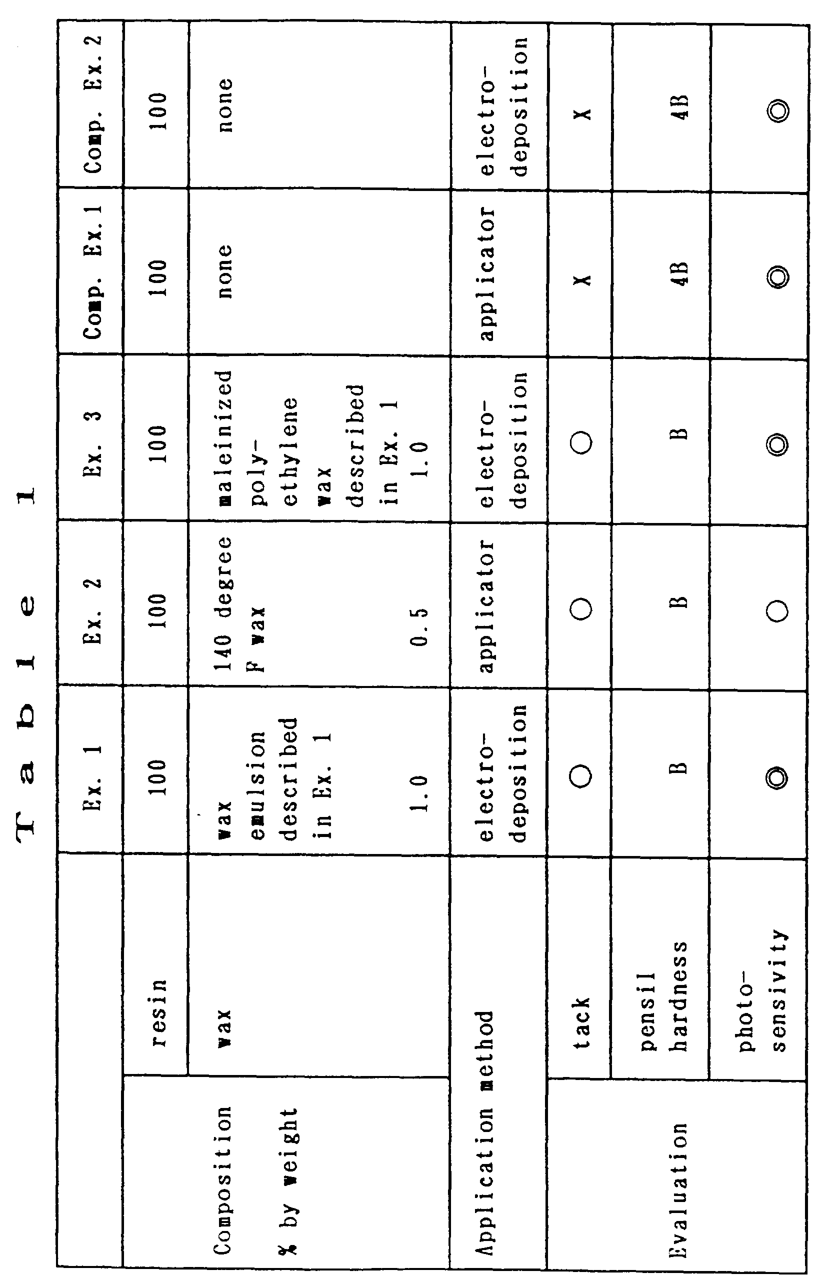

### (tack test)

A cooper clad laminate having a photosensitive coating formed thereon was put in a dark thermohumidistat at 30 ^{o}C. A negative mask (made of PET film) having a circuit pattern drawn thereon was put on the coating. A glass plate having a thickness of 1.5 mm and a weight were put on the mask to thereby apply a pressure of 0.2 kg/cm (corresponding to a pressure applied in case of vacuum adhesion) to the interface between the mask and the coating. This condition was kept for 5 minutes, followed by the removal of the glass plate and the weight. Then, the mask was peeled off to evaluate the peel properties according to the following criteria. In this test, the test apparatus to be used was heated to the temperature of the testing atmosphere prior to its use.
- ○:: the mask was peeled off without making any peel noise and without any resistance.
- X:: the peeling of the mask gave some resistance and made a distinct peel noise.

### (photosensitivity test)

Using an evaluation-purpose circuit pattern mask having 30 µm-wide, 50 µm-wide and 100 µm-wide pattern lines, there were formed pattern lines under the following exposure and development conditions to evaluate the pattern reproducibility by microscopic observation.
- ⓞ:: a pattern was formed (the line of 30 µm-wide or more was reproduced)
- ○:: a pattern was formed (the line of 50 µm-wide or more was reproduced)
- X:: no pattern was formed

(1) exposure conditions
   - apparatus :: UVC-2613 mfd. by Ushio Electric Inc.
   - light source :: metal halide lamp
   - quantity of light :: 170 mJ/cm
(2) development conditions
   - apparatus :: spray equipment made by Nippon Petrochemicals Co. Ltd.
   (spray pressure : 1.35 kg/cm)
   - developer :: 1 % aqueous sodium carbonate solution
   - temperature of the developing solution :: 30 °C

## Claims

1. A photocurable resin composition comprising
(a) 100 parts by weight of a modified resin prepared by reacting an α,β-unsaturated dicarboxylic acid anhydride adduct having a softening point ranging from 70 to 200 °C (as determined by the ring and ball softening point method, according to JIS K 2531-60) and derived from a conjugated diene polymer or copolymer having a number average molecular weight of 500 to 5000 and a vinyl group content of at least 50 mole %, with N-methylolacrylamide or with an α,β-unsaturated monocarboxylic acid ester having an alcoholic hydroxyl group represented by the following general formula (I), 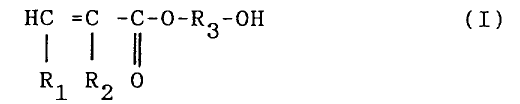 wherein R₁ and R₂ each represent a hydrogen atom or a methyl group, and R₃ represents a hydrocarbon residue having at least 2 carbon atoms which may contain a heteroatom therein,
to cause ring opening of at least 10 mole % of the acid anhydride present in the adduct,
(b) 0.2 to 10 parts by weight of a wax having a melting point of not higher than 100 °C (as determined by the dropping method according to ASTM D 127), and
(c) 0.1 to 20 parts by weight of a photopolymerization initiator.

2. A photocurable resin composition according to claim 1, wherein said α,β-unsaturated dicarboxylic acid anhydride is maleic acid anhydride.

3. A photocurable resin composition according to claim 1, wherein said α,β-unsaturated monocarboxylic acid ester is a member selected from the group consisting of 2-hydroxyethyl acrylate, 2-hydroxylethyl methacrylate, 2-hydroxypropyl acrylate, 2-hydroxypropyl methacrylate, 2-hydroxy-3-phenoxypropyl acrylate and 2-hydroxy-3-phenoxypropyl methacrylate.

4. A photocurable resin composition according to claim 1, wherein said conjugated diene is butadiene.

5. A photocurable resin composition according to claim 1, wherein said wax in said component (b) is a maleinized wax.

6. A photocurable resin composition according to claim 1, wherein said wax in said component (b) is in the form of an emulsion of a maleinized wax.

## Patentansprüche

1. Lichthärtende Harzzusammensetzung, umfassend:
(a) 100 Gewichtsteile eines modifizierten Harzes, hergestellt durch Umsetzen eines Addukts von α,β-ungesättigtem Dicarbonsäureanhydrid, das einen Erweichungspunkt im Bereich von 70 bis 200°C hat (bestimmt mit dem Erweichungspunktbestimmungsverfahren mit Ring und Kugel nach JIS K 2531-60) und das hergestellt ist aus einem Polymer oder Copolymer mit konjugiertem Dien und mit einem Zahlenmittel des Molekulargewichts von 500 bis 5000 sowie einem Vinylgruppengehalt von mindestens 50 Mol%, mit N-Methylolacrylamid oder einem α,β-ungesättigten Monocarbonsäureester mit einer alkoholischen Hydroxylgruppe der folgenden allgemeinen Formel (I) 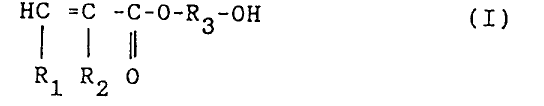 worin R₁ und R₂ jeweils ein Wasserstoffatom oder eine Methylgruppe darstellen, und R₃ ein Kohlenwasserstoffrest mit mindestens zwei Kohlenstoffatomen ist, der ein Heteroatom enthalten kann,
wodurch die Ringöffnung von mindestens 10 Mol% des im Addukt vorhandenen Säureanhydrids erfolgt,
(b) 0,2 bis 10 Gewichtsteile Wachs mit einem Schmelzpunkt von nicht mehr als 100°C (bestimmt mit dem Tropfverfahren nach ASTM D 127) und
(c) 0,1bis 20 Gewichtsteile eines Photopolymerisations-initiators.

2. Lichthärtende Harzzusammensetzung nach Anspruch 1, wobei das α,β-ungesättigte Dicarbonsäureanhydrid Maleinsäureanhydrid ist.

3. Lichthärtende Harzzusammensetzung nach Anspruch 1, wobei der α,β-ungesättigte Monocarbonsäureester eine Verbindung ist aus der Gruppe mit 2-Hydroxyethylacrylat, 2-Hydroxyethylmethacrylat, 2-Hydroxypropylacrylat, 2-Hydroxypropylmethacrylat, 2-Hydroxy-3-phenoxypropylacrylat und 2-Hydroxy-3-phenoxypropylmethacrylat.

4. Lichthärtende Harzzusammensetzung nach Anspruch 1, wobei das konjugierte Dien Butadien ist.

5. Lichthärtende Harzzusammensetzung nach Anspruch 1, wobei das Wachs in der Komponente (b) maleinisiertes Wachs ist.

6. Lichthärtende Harzzusammensetzung nach Anspruch 1, wobei das Wachs in der Komponente (b) in Form einer Emulsion von maleinisiertem Wachs vorliegt.

## Revendications

1. Composition de résine photodurcissable, comprenant
(a) 100 parties en poids d'une résine modifiée, que l'on prépare en faisant réagir un produit d'addition d'un anhydride d'acide dicarboxylique à insaturation en α-β, ayant un point de ramollissement compris entre 70 et 200°C (tel que déterminé par la méthode de détermination du point de ramollissement à l'aide d'un appareil à bille et anneau, selon la norme JIS K 2531-60), et provenant d'un polymère ou copolymère de diène conjugué ayant un poids moléculaire moyen en nombre valant 500 à 5 000 et une teneur en des groupes vinyles d'au moins 50 %, avec du N-méthylolacrylamide ou avec un ester d'acide monocarboxylique insaturé en α-β, comportant un groupe hydroxyle alcoolique, représenté par la formule générale (I) suivante : 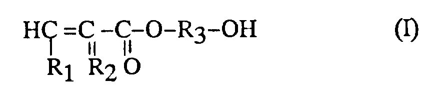 dans laquelle R₁ et R₂ représentent chacun un atome d'hydrogène ou un groupe méthyle ; et R₃ représente un reste hydrocarboné comportant au moins deux atomes de carbone, qui peut contenir un hétéroatome,
pour provoquer une ouverture de cycle correspondant à au moins 10 mol % de l'anhydride d'acide présent dans le produit d'addition;
(b) 0,2 à 10 parties en poids d'une cire ayant un point de fusion non supérieur à 100°C (ce qui est déterminé par la méthode de chute selon la norme ASTM D 127), et
(c) 0,1 à 20 parties en poids d'un amorceur de photopolymérisation.

2. Composition de résine photodurcissable selon la revendication 1, dans laquelle ledit anhydride d'acide dicarboxylique à insaturation en α-β est l'anhydride de l'acide maléique.

3. Composition de résine photodurcissable selon la revendication 1, dans laquelle ledit ester d'acide monocarboxylique insaturé en α-β est un membre choisi dans l'ensemble consistant en l'acrylate de 2-hydroxyéthyle, le méthacrylate de 2-hydroxyéthyle, l'acrylate de 2-hydroxypropyle, le méthacrylate de 2-hydroxypropyle, l'acrylate de 2-hydroxy-3-phénoxypropyle et le méthacrylate de 2-hydroxy-3-phénoxypropyle.

4. Composition de résine photodurcissable selon la revendication 1, dans laquelle ledit diène conjugué est du butadiène.

5. Composition de résine photodurcissable selon la revendication 1, dans laquelle ladite cire présente dans le conjugué (b) est une cire maléinisée.

6. Composition de résine photodurcissable selon la revendication 1, dans laquelle ladite cire présente dans le constituant (b) est sous forme d'une émulsion d'une cire maléinisée.
